# DEMANDE DE BREVET EUROPEEN

(11) **EP 4 287 263 A1**
(43) Date de publication de la demande: **06.12.2023**
(21) Numéro de dépôt: 23173823.8
(22) Date de dépôt: 17.05.2023
(51) Int. Cl.: H01L 29/735, H01L 21/331, H01L 29/417, H01L 29/08, H01L 29/40, H01L 29/36

(54) **TRANSISTOR BIPOLAIRE LATÉRAL**

(30) Priorité: 31.05.2022 FR 2205185
(71) Demandeur: STMicroelectronics Crolles 2 SAS, 38920 Crolles (FR)
(72) Inventeur: CHEVALIER, Pascal, 38530 CHAPAREILLAN (FR); FREGONESE, Sebastien, 33850 LEOGNAN (FR); ZIMMER, Thomas, 33400 TALENCE (FR)
(74) Mandataire: Cabinet Beaumont

(57) **Abrégé**

La présente description concerne un transistor bipolaire latéral (100) comprenant :
- une région d'émetteur (112) dopée d'un premier type de conductivité et présentant une première largeur (L12) ;
- une région de collecteur (116) dopée du premier type de conductivité, présentant une deuxième largeur (L16) supérieure à la première largeur et une concentration moyenne de dopage inférieure à la concentration moyenne de dopage de la région d'émetteur ;
- une région de base (114) entre les régions d'émetteur et de collecteur dopée du deuxième type de conductivité; lesdites régions étant disposées dans une couche de silicium (110) sur une couche d'isolant (104) sur un substrat (102) ;
- une région de substrat (106) dépourvue des couches de silicium et d'isolant, et positionnée du côté de la région de collecteur (116) ; et
- un circuit de polarisation (150) relié, et adapté à fournir, à la région de substrat une tension de polarisation de manière à moduler le dopage électrostatique de la région de collecteur.

## Description

### Domaine technique

La présente description concerne de façon générale les composants électroniques et plus précisément les transistors bipolaires et leur procédé de fabrication. La présente description concerne en particulier les transistors bipolaires latéraux, et des circuits électroniques comprenant au moins un transistor bipolaire latéral.

### Technique antérieure

Un transistor bipolaire est un composant électronique à base de semiconducteur de la famille des transistors. Son principe de fonctionnement est basé sur deux jonctions PN, l'une en direct et l'autre en inverse, les deux jonctions étant formées par une région de base comprise entre une région d'émetteur et une région de collecteur.

Un transistor bipolaire latéral est un transistor bipolaire dans lequel les régions d'émetteur, de base et de collecteur sont disposées l'une à côté de l'autre dans, et dans certains cas sur, un substrat de semiconducteur, à la différence d'un transistor bipolaire vertical où ces régions sont disposées l'une sur l'autre. Un transistor bipolaire latéral est bien adapté à l'intégration dans un procédé CMOS (Complementary Métal Oxide Semiconductor), par exemple en raison de nombreuses similitudes structurelles entre un transistor bipolaire latéral et un transistor à effet de champ à grille isolée (MOSFET, metal-oxide-semiconductor field-effect transistor).

Dans certaines applications, il est recherché l'amélioration de caractéristiques d'un transistor bipolaire latéral, par exemple l'augmentation de sa rapidité de commutation et/ou de sa tension de claquage, pour lesquels on recherche généralement le meilleur compromis pour l'application visée.

### Résumé de l'invention

Un mode de réalisation pallie tout ou partie des inconvénients des transistors bipolaires connus, en particulier des transistors bipolaires latéraux connus.

Un mode de réalisation prévoit un transistor bipolaire latéral comprenant :
- une région d'émetteur dopée d'un premier type de conductivité et présentant une première largeur ;
- une région de collecteur dopée du premier type de conductivité, présentant une deuxième largeur supérieure à la première largeur de la région d'émetteur et une concentration moyenne de dopage inférieure à la concentration moyenne de dopage de la région d'émetteur ;
- une région de base dopée du deuxième type de conductivité et positionnée latéralement entre la région d'émetteur et la région de collecteur ;
   lesdites régions d'émetteur, de base et de collecteur étant disposées dans une couche de silicium sur une couche d'isolant, ladite couche d'isolant étant sur un substrat semiconducteur ;
- une région de substrat dépourvue de la couche de silicium et de la couche d'isolant, et positionnée latéralement du côté de la région de collecteur ; et
- un circuit de polarisation relié à la région de substrat, et adapté à fournir à ladite région de substrat une tension de polarisation de manière à moduler le dopage électrostatique de la région de collecteur.

Selon un mode de réalisation, le transistor comprend une base extrinsèque présentant une troisième largeur et disposée sur la région de base présentant une quatrième largeur.

Selon un mode de réalisation particulier, la troisième largeur de la base extrinsèque est inférieure à la quatrième largeur de la région de base, la base extrinsèque étant par exemple sensiblement centrée par rapport à la région de base.

Selon un mode de réalisation, le transistor comprend une première portion d'isolant sur une première portion de la région d'émetteur et une deuxième portion d'isolant sur une première portion de la région de collecteur, la région de base étant entre la première portion de la région d'émetteur et la première portion de la région de collecteur, et la base extrinsèque étant entre la première portion d'isolant et la deuxième portion d'isolant.

Selon un mode de réalisation, la couche de silicium a une épaisseur comprise entre quelques nanomètres et une quinzaine de nanomètres, par exemple entre 5 et 15 nanomètres.

Selon un mode de réalisation, la couche d'isolant a une épaisseur comprise entre quelques nanomètres et quelques dizaines de nanomètres, par exemple entre 10 et 50 nanomètres.

Selon un mode de réalisation, la région d'émetteur est formée par une région fortement dopée du premier type de conductivité.

Selon un mode de réalisation, la région de collecteur comprend une première sous-région légèrement dopée du premier type de conductivité et une deuxième sous-région fortement dopée du premier type de conductivité.

Selon un mode particulier de réalisation, la première sous-région de la région de collecteur est entre la région de base et la deuxième sous-région de la région de collecteur.

Selon un mode particulier de réalisation, la première sous-région de la région de collecteur a une concentration moyenne de dopage en le premier type de conductivité inférieure à la concentration moyenne de dopage de la région de base en le deuxième type de conductivité, par exemple d'un facteur d'au moins dix.

Selon un mode de réalisation, la région de base comprend un alliage silicium et germanium.

Selon un mode de réalisation, le transistor comprend une première tranchée isolante traversant la couche de silicium, la couche d'isolant et, partiellement, le substrat semiconducteur, ladite première tranchée isolante étant positionnée latéralement entre la région de collecteur et la région de substrat.

Selon un mode de réalisation, le transistor comprend une deuxième tranchée isolante traversant la couche de silicium, la couche d'isolant et, partiellement, le substrat semiconducteur, la région d'émetteur étant positionnée latéralement entre ladite deuxième tranchée isolante et la région de base.

Selon un mode de réalisation, une zone du substrat située au moins sous la région de substrat dépourvue de la couche de silicium et de la couche d'isolant, et de préférence sous la région de collecteur, est dopée, par exemple avec un dopage graduel décroissant radialement depuis ladite région du substrat.

Selon un mode de réalisation, le transistor comprend des prises de contact sur la région d'émetteur, la région de collecteur, la région de substrat, et, dans certains cas, sur la base extrinsèque, le circuit de polarisation étant relié à la région de substrat par une desdites prises de contact, une portion de siliciure étant par exemple formée sous chaque prise de contact.

Un mode de réalisation prévoit un procédé de fabrication d'un transistor bipolaire, ledit procédé comprenant :
- la fourniture d'une couche de silicium sur une couche d'isolant, sur un substrat semiconducteur ;
- la formation, dans la couche de silicium, d'une région d'émetteur d'une première largeur dopée d'un premier type de conductivité ; d'une région de collecteur dopée du premier type de conductivité avec une deuxième largeur supérieure à la première largeur et une concentration moyenne de dopage inférieure à la concentration moyenne de dopage de la région d'émetteur ; et d'une région de base dopée du deuxième type de conductivité et formée latéralement entre ladite région d'émetteur et ladite région de collecteur ;
- la formation d'une région de substrat dépourvue de la couche de silicium et de la couche d'isolant, ladite région de substrat étant formée latéralement du côté de la région de collecteur ;
- la formation d'un circuit de polarisation relié à la région de substrat, et adapté à fournir à ladite région de substrat une tension de polarisation de manière à moduler le dopage électrostatique de la région de collecteur.

Selon un mode de réalisation, le procédé comprend, préalablement à la formation des régions d'émetteur, de base, de collecteur et de substrat :
- la formation d'une première tranchée isolante dans la couche de silicium, la couche d'isolant, et partiellement dans le substrat, ladite première tranchée isolante étant formée latéralement entre la région de collecteur et l'emplacement de la future région de substrat ; et
- la formation d'une deuxième tranchée isolante dans la couche de silicium, la couche d'isolant et partiellement dans le substrat, la région d'émetteur étant positionnée latéralement entre ladite deuxième tranchée isolante et la région de base.

Un mode de réalisation prévoit un procédé d'utilisation d'un transistor selon un mode de réalisation, ledit procédé comprenant l'application, par le circuit de polarisation, d'une tension de polarisation à la région de substrat.

Selon un mode de réalisation, le procédé d'utilisation comprend l'application d'une tension de polarisation positive à la région de substrat, de manière à augmenter la rapidité et/ou le gain du transistor.

Selon un mode de réalisation, le procédé d'utilisation comprend l'application d'une tension de polarisation négative à la région de substrat, de manière à augmenter la tension de claquage du transistor.

Un mode de réalisation prévoit un circuit électronique comprenant au moins un transistor selon un mode de réalisation.

Un mode de réalisation prévoit un circuit électronique comprenant plusieurs transistors selon un mode de réalisation, au moins deux transistors ayant des tensions de polarisation différentes appliquées à la région de substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe représentant un transistor bipolaire latéral selon un mode de réalisation ;
la figure 2 est une vue en coupe représentant un transistor bipolaire latéral selon une variante du mode de réalisation de la figure 1 ;
la figure 3 est une vue en coupe représentant un transistor bipolaire latéral selon une autre variante du mode de réalisation de la figure 1 ;
la figure 4A, la figure 4B, la figure 4C, la figure 4D, la figure 4E et la figure 4F sont des vues en coupe représentant des étapes d'un procédé de fabrication d'un transistor bipolaire latéral selon un mode de réalisation ;
la figure 5 est une vue en coupe représentant un transistor bipolaire symétrique ;
la figure 6 représente des courbes donnant la fréquence de transition du gain en courant (f_{T}) et la fréquence maximum d'oscillation (fₘₐₓ) en fonction du courant de collecteur (I_{c}), et ce, pour plusieurs valeurs de polarisation du substrat (V_{SUB}), et pour plusieurs exemples de transistors bipolaires latéraux ;
la figure 7 représente des courbes I(V) donnant le courant de collecteur en fonction de la tension du collecteur, et ce, pour plusieurs valeurs de polarisation du substrat (V_{SUB}), et pour plusieurs exemples de transistors bipolaires latéraux ;
la figure 8 représente des courbes donnant la densité d'électrons et la densité de trous en fonction de la distance latérale par rapport à la jonction base/émetteur, et ce, pour plusieurs valeurs de polarisation du substrat (V_{SUB}), et pour un transistor bipolaire latéral symétrique et un transistor bipolaire latéral asymétrique ;
la figure 9 représente un circuit électronique comprenant plusieurs transistors bipolaires latéraux selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, toutes les étapes de fabrication et les détails des éléments d'un transistor bipolaire latéral, par exemple la formation de portions de siliciure (siliciuration, ou "salicidation" en anglais) sur des régions semiconductrices et/ou la prise de contact, ne sont pas détaillés, étant réalisables avec les procédés usuels connus de la personne du métier.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un transistor bipolaire latéral dans une position normale d'utilisation.

Dans la description qui suit, une largeur ou une distance correspond à une dimension dans la direction latérale d'un transistor bipolaire latéral, qui correspond à la direction horizontale X repérée dans les figures, et une épaisseur ou une profondeur correspond à une dimension dans la direction verticale Z repérée dans les figures.

Sauf précision contraire, les expressions "environ", "approximativement", "sensiblement", et "de l'ordre de" signifient à 10 % près, de préférence à 5 % près.

Les modes de réalisation représentés sur les figures, et décrits dans la description qui suit, comportent un transistor bipolaire latéral de type NPN, le dopage N correspondant au premier type de conductivité, et le dopage P au deuxième type de conductivité.

Cependant, la personne du métier comprendra facilement que les principes décrits dans la présente description peuvent également être appliqués à un transistor bipolaire latéral de type PNP, le dopage P correspondant alors au premier type de conductivité, et le dopage N au deuxième type de conductivité.

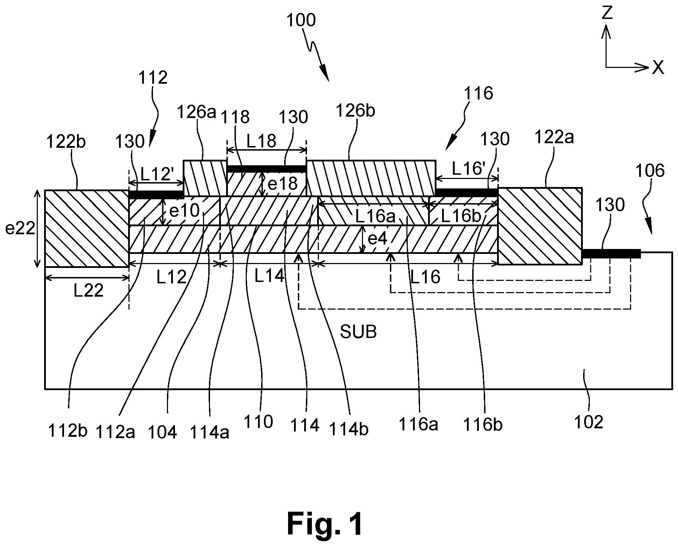

La figure 1 est une vue en coupe représentant un transistor bipolaire 100 selon un mode de réalisation.

Le transistor 100 représenté est fabriqué en technologie SOI et comprend un substrat 102 (SUB), un isolant 104 créé dans le substrat 102 en utilisant, par exemple, un procédé SIMOX ou un procédé SMARTCUT, et une fine couche de silicium monocristallin (Si) 110 sur l'isolant 104. Par exemple, le substrat 102 est à base de silicium (Si). L'isolant 104 peut être un oxyde (BOX, de l'anglais Buried Oxide), par exemple à base de dioxyde de silicium (SiO₂).

De préférence, le transistor est en technologie dite "Fully-Depleted SOI" (FD-SOI), c'est-à-dire permettant de fonctionner en mode totalement déplété, en référence au fonctionnement des transistors CMOS FD-SOI.

De préférence, la fine couche de silicium 110 a une épaisseur e10 comprise entre quelques nanomètres et une quinzaine de nanomètres, par exemple entre 5 et 15 nm.

De préférence, la couche d'isolant 104 a une épaisseur e4 comprise entre quelques nanomètres et quelques dizaines de nanomètres, par exemple entre 10 et 50 nm.

Le transistor 100 comprend une région d'émetteur 112 dopé N, une région de collecteur 116 dopé N et une région de base 114 dopé P formée entre la région d'émetteur 112 et la région de collecteur 116.

La région d'émetteur 112, la région de base 114 et la région de collecteur 116 sont formées latéralement l'une à côté de l'autre dans la couche de silicium 110, la région de base étant entre la région d'émetteur et la région de collecteur.

La région d'émetteur 112 est fortement dopée N (N+), la région de base 114 est fortement dopée P (P+) et la région de collecteur 116 comprend une première sous-région de collecteur 116a légèrement dopée N (N-) et une deuxième sous-région de collecteur 116b fortement dopée N (N+), la première sous-région de collecteur 116a étant disposée entre la région de base 114 et la deuxième sous-région de collecteur 116b. Cette différence de dopage entre l'émetteur et le collecteur crée une asymétrie de dopage du transistor. En outre, la largeur L16 de la région de collecteur 116 est supérieure à la largeur L12 de la région d'émetteur 112, créant une asymétrie géométrique du transistor. Ainsi, le transistor 100 est dit asymétrique géométriquement et par le dopage. Par exemple, "fortement dopé" signifie avoir une concentration moyenne de dopage supérieure ou égale à 1,10¹⁹ at/cm³ et "légèrement dopé" signifie avoir une concentration moyenne de dopage inférieure à 1,10¹⁹ at/cm³.

La portion de la couche de silicium correspondant à la région de base 114 peut être traitée afin de former un alliage silicium-germanium (SiGe) dans ladite région de base. Le germanium dans la base permet d'améliorer les performances du transistor, qui est alors de type hétérojonction (HBT, de l'anglais Heterojunction Bipolar Transistor). Par exemple, l'ajout de germanium dans la région de base peut réduire la tension entre la région d'émetteur et la région de base en raison de la bande interdite plus petite de l'alliage SiGe par rapport au silicium. Selon un mode alternatif, la région de base est en silicium, le transistor étant alors un transistor du type à homojonction (BJT, de l'anglais Bipolar Junction Transistor).

Cette région de base 114 correspond à une région de base dite "intrinsèque" (partie active de la base, comprise entre la région d'émetteur et la région de collecteur).

Cette région de base intrinsèque est surmontée par une région de base dite "extrinsèque" 118, qui peut également être désignée par le terme de "base extrinsèque", et qui est une partie de connexion électrique, par l'intermédiaire de laquelle la région intrinsèque de base 114 peut être polarisée lors du fonctionnement du transistor. La base extrinsèque 118 est par exemple à base de silicium polycristallin, ou polysilicium (Poly).

De préférence, la largeur L18 de la base extrinsèque 118 est inférieure à la largeur L14 de la région de base 114, et la base extrinsèque positionnée par rapport à la région de base de sorte que des première et deuxième portions 114a, 114b aux deux extrémités latérales de la région de base 114 ne soient pas recouvertes par la base extrinsèque 118.

Par exemple, la largeur L14 de la région de base 114 est comprise entre environ 10 et 100 nm, et la largeur L18 de la base extrinsèque 118 est comprise entre environ 5 et 90 nm, la base extrinsèque pouvant être sensiblement centrée par rapport à la région de base.

En outre, une portion 112a (première sous-région d'émetteur) de la région d'émetteur 112 et la première portion 114a de la région de base 114 non recouverte par la base extrinsèque 118 sont recouvertes par une première portion d'isolant 126a (ou premier espaceur), de préférence un oxyde, par exemple du SiO₂. Similairement, une portion de la région de collecteur 116 et la deuxième portion 114b de la région de base 114 non recouverte par la base extrinsèque 118 sont recouvertes par une deuxième portion d'isolant 126b (ou deuxième espaceur), de préférence un oxyde, par exemple du SiO₂. Ces espaceurs permettent d'isoler électriquement la base extrinsèque 118 de chacune des régions d'émetteur 112 et de collecteur 116. Le fait que les première 114a et deuxième 114b portions de la région de base 114 ne soient pas recouvertes par la base extrinsèque 118, mais soient recouvertes respectivement par les premier 126a et deuxième 126b espaceurs permet d'améliorer l'isolation de ladite base extrinsèque vis-à-vis de chacune des régions d'émetteur 112 et de collecteur 116.

Des tranchées isolantes 122a, 122b sont formées (creusées puis remplies d'un isolant) dans la fine couche de silicium 110, dans l'isolant 104 et dans le substrat 102 sur une certaine profondeur, afin de séparer le transistor 100 de composants électroniques adjacents pouvant être mis en œuvre dans la couche de silicium 110. Plus précisément, les tranchées isolantes 122a, 122b traversent le substrat 102 partiellement, sur une épaisseur très inférieure à l'épaisseur dudit substrat, et peuvent être désignées par le terme anglosaxon "Shallow Trench Isolation" (STI). Elles peuvent être remplies d'un isolant oxyde, par exemple du SiO₂. Une première tranchée isolante 122a est positionnée latéralement contre la région de collecteur 116, et dans le mode représenté contre la deuxième sous-région de collecteur 116b, et une deuxième tranchée isolante 122b est positionnée latéralement contre la région d'émetteur 112.

Par exemple, la largeur L16 de la région de collecteur 116 est comprise entre environ 30 et 400 nm ou entre environ 30 et 300 nm, la largeur L16a de la première sous-région de collecteur 116a est comprise entre environ 15 et 200 nm, la largeur L16b de la deuxième sous-région de collecteur 116b est comprise entre environ 15 et 200 nm, et la largeur L12 de la région d'émetteur 112 est comprise entre environ 15 et 200 nm.

Il est à noter que, dans les modes de réalisation décrits, la largeur L16 de la région de collecteur 116 correspond sensiblement à la distance entre la région de base 114 et la première tranchée isolante 122a, et la largeur L12 de la région d'émetteur 112 correspond sensiblement à la distance entre la deuxième tranchée isolante 122b et la région de base 114.

Dans le transistor 100 représenté en figure 1, la région d'émetteur 112 et la région de collecteur 116 ont une profondeur telle qu'elles s'étendent jusqu'à l'isolant 104, confinant la région de base 114 entre elles.

Dans le transistor 100 représenté en figure 1, le deuxième espaceur 126b recouvre la première sous-région de collecteur 116a et déborde sur la deuxième sous-région de collecteur 116b. Ceci peut permettre, par exemple, de prendre en compte des possibles erreurs d'alignement lors de la formation des espaceurs (comme décrite plus après), et assurer notamment que le deuxième espaceur 126b soit toujours un peu plus large que la première sous-région de collecteur 116a, de sorte que celle-ci ne soit pas siliciurée.

En outre, le transistor 100 comprend une région de substrat 106 dans laquelle, sur le substrat 102, la couche de silicium 110 et la couche d'isolant 104 ont été supprimées, par exemple gravées. Une telle région est connue par la personne du métier par le terme "région sans SOI" ou région "NO-SO". Cette région de substrat 106 est positionnée latéralement de l'autre côté de la première tranchée isolante 122a par rapport à la région de collecteur 116, et dans le mode représenté par rapport à la deuxième sous-région de collecteur 116b. En d'autres termes, la première tranchée isolante 122a est entre la région de collecteur 116 et la région NO-SO 106, permettant d'isoler latéralement ces deux régions l'une de l'autre. La région NO-SO 106 permet de contacter le substrat en vue de le polariser selon une technique dite de "back-biasing" (polarisation par le substrat) comme expliqué plus après.

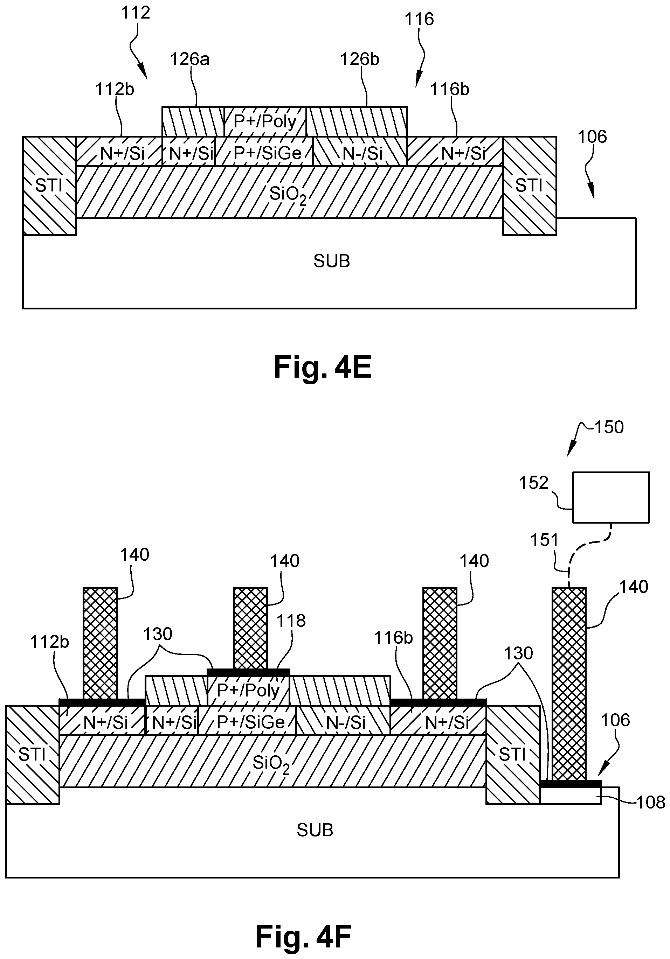

Sur l'autre portion 112b (deuxième sous-région d'émetteur) de la région d'émetteur 112 non recouverte par le premier espaceur 126a, sur la portion de la région de collecteur 116 non recouverte par le deuxième espaceur 126b, sur la base extrinsèque 118 et sur au moins une portion de la région NO-SO 106, peut être formée une portion de siliciure de métal 130 (désigné "siliciure"), et une prise de contact électrique 140 ou "contact" (les contacts sont visibles en figure 4F) sur chaque portion de siliciure. Une telle portion de siliciure permet de réduire fortement la valeur de la résistance électrique du contact, c'est-à-dire la résistance entre la région semiconductrice et le contact.

De préférence, comme représenté en figure 1, la portion de la région de collecteur 116 non recouverte par le deuxième espaceur 126b est une portion de la deuxième sous-région de collecteur 116b, de sorte que la portion de siliciure 130 est formée sur la sous-région la plus dopée de la région de collecteur 116, et ce, afin de réduire la résistance d'accès au collecteur.

Le contact 140 sur la région NO-SO 106, de préférence recouverte de siliciure 130, permet d'appliquer à la région de collecteur 116 une tension de polarisation, de manière à moduler la charge par effet électrostatique dans la sous-région la plus faiblement dopée du collecteur, c'est-à-dire la première sous-région de collecteur 116a, comme expliqué plus après. Une telle polarisation peut être réalisée à l'aide d'un circuit de polarisation 150, comprenant par exemple une ligne de polarisation 151 reliée d'une part à un générateur de tension 152 et d'autre part à la région de substrat NO-SO via son contact 140 (circuit représenté en figure 4F).

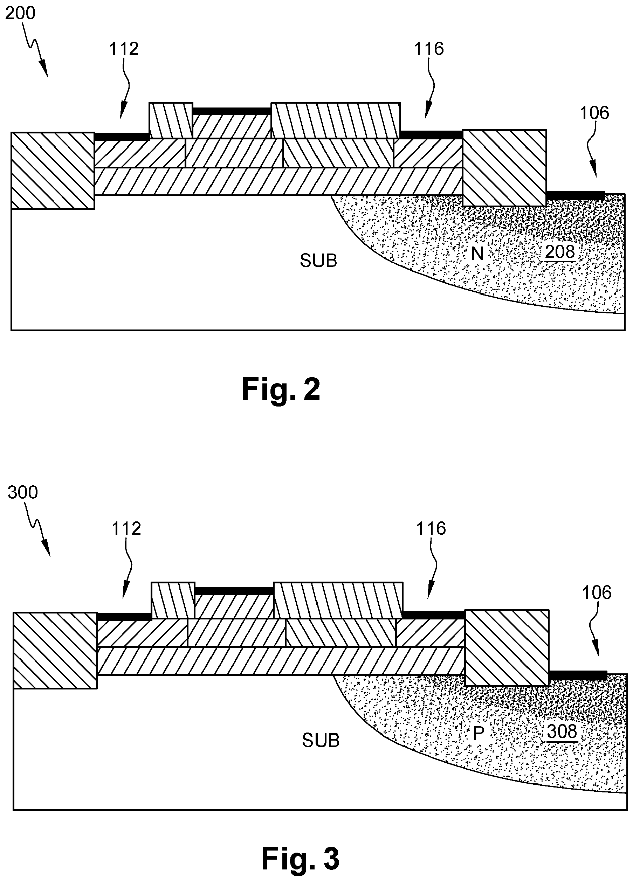

La figure 2 est une vue en coupe représentant un transistor bipolaire latéral 200 selon une variante du mode de réalisation de la figure 1, qui s'en distingue en ce qu'une zone 208 de substrat située au moins sous la région NO-SO 106, et de préférence sous la région de collecteur 116, est dopée N avec un dopage qui peut être graduel, décroissant radialement à partir de la région NO-SO, par exemple selon un profil gaussien.

La figure 3 est une vue en coupe représentant un transistor bipolaire latéral 300 selon une autre variante du mode de réalisation de la figure 1, qui s'en distingue en ce qu'une zone 308 de substrat située au moins sous la région NO-SO 106, et de préférence sous la région de collecteur 116, est dopée P, avec un dopage qui peut être graduel, décroissant radialement à partir de la région NO-SO, par exemple selon un profil gaussien.

Le transistor bipolaire latéral selon un mode de réalisation est donc construit de manière asymétrique et comprend une région NO-SO positionnée latéralement à proximité de la région de collecteur, lesdites régions étant séparées latéralement par une tranchée isolante. En appliquant une polarisation au substrat via un contact sur la région NO-SO, des caractéristiques dudit transistor peuvent être contrôlées. En particulier, la polarisation du substrat permet de moduler le dopage "électrostatique", c'est-à-dire de moduler la charge par effet électrostatique (couplage électrostatique avec les régions du transistor), de la sous-région faiblement dopée du collecteur, voire de la région de base dans une moindre mesure, par une technique de "back-biasing", c'est-à-dire en passant par le substrat, comme illustré dans la figure 1 par les flèches en pointillés.

La tension de polarisation appliquée au substrat peut par exemple être de quelques volts, en positif ou en négatif, par exemple entre environ 0,5 et 2 volts, et ce, en fonction de l'épaisseur de l'isolant 104.

Avec un transistor bipolaire latéral en technologie "Fully-Depleted SOI" (FD-SOI), et par exemple dans les plages d'épaisseurs de couche Si et de couche d'isolant du SOI données plus avant, la tension de polarisation appliquée au substrat peut être réduite, même lorsqu'on souhaite aussi moduler la région de base par la polarisation du substrat. Il est donc avantageux de combiner la technologie FD-SOI avec la polarisation du substrat.

En outre, le caractère asymétrique du collecteur, par rapport à la région d'émetteur, qui est à la fois une asymétrie de dopage (région de collecteur "en moyenne" moins dopée que la région d'émetteur) et une asymétrie géométrique (région de collecteur plus large que la région d'émetteur) permet d'une part d'avoir un dopage de la région de collecteur suffisamment faible. En effet, les inventeurs ont déterminé que le dopage électrostatique du collecteur était plus efficace si le dopage initial dudit collecteur était plus faible, voire beaucoup plus faible, que dans un transistor bipolaire symétrique. Typiquement, le dopage du collecteur est compris entre 1.10¹⁶ et 1.10¹⁸ at/cm³ pour un transistor bipolaire latéral selon un mode de réalisation, à comparer avec des valeurs de l'ordre de 1.10¹⁹ à 1.10²¹ at/cm³ pour un transistor bipolaire symétrique.

L'influence du couplage électrostatique du substrat avec les régions du transistor est directement liée au niveau des charges présentes dans chaque région et donc au dopage de chaque région. Ainsi, les régions d'accès, ou extrinsèques, (fortement dopées) du transistor, correspondant à la deuxième sous-région d'émetteur 112b et à la deuxième sous-région de collecteur 116b, ainsi que la région intrinsèque fortement dopée, correspondant à la première sous-région d'émetteur 112a, ne seront que très peu impactées par le couplage électrostatique du substrat. Seules la région de base 114 (intrinsèque) et la région de collecteur intrinsèque, correspondant à la première sous-région de collecteur 116a (faiblement dopée), seront impactées par le couplage électrostatique du substrat. Aussi, si le dopage du collecteur intrinsèque 116a est très inférieur à celui de la région de base intrinsèque 114, le couplage électrostatique jouera de façon prépondérante sur la région de collecteur intrinsèque 116a.

En outre, les inventeurs ont déterminé que, si le back-biasing a un impact principalement, et de façon homogène, le long de la direction verticale Z dans le collecteur intrinsèque 116a, l'effet du back-biasing peut également atteindre l'interface de la région de base 114 avec l'isolant 104.

Un collecteur intrinsèque 116a très faiblement dopé associé à l'ensemble substrat 102 et isolant 104 permet une modulation du dopage effectif ou de la charge dans ledit collecteur intrinsèque par effet électrostatique en appliquant une tension sur la région NO-SO 106 du substrat 102. On verra plus après que cela permet, par exemple, de commuter le transistor d'un mode de fonctionnement très rapide à un mode de fonctionnement à forte tension.

D'autre part, les inventeurs ont déterminé que le dopage électrostatique du collecteur était plus efficace si la largeur de la région de collecteur était plus grande, afin de favoriser davantage la modulation du dopage électrostatique du collecteur que celle de la région de base. Le principe est en effet bien de moduler le dopage électrostatique de la région de collecteur, et, dans une moindre mesure, celui de la région de base.

Il est à noter que l'efficacité du dopage électrostatique peut également dépendre du dopage du substrat, comme expliqué plus après.

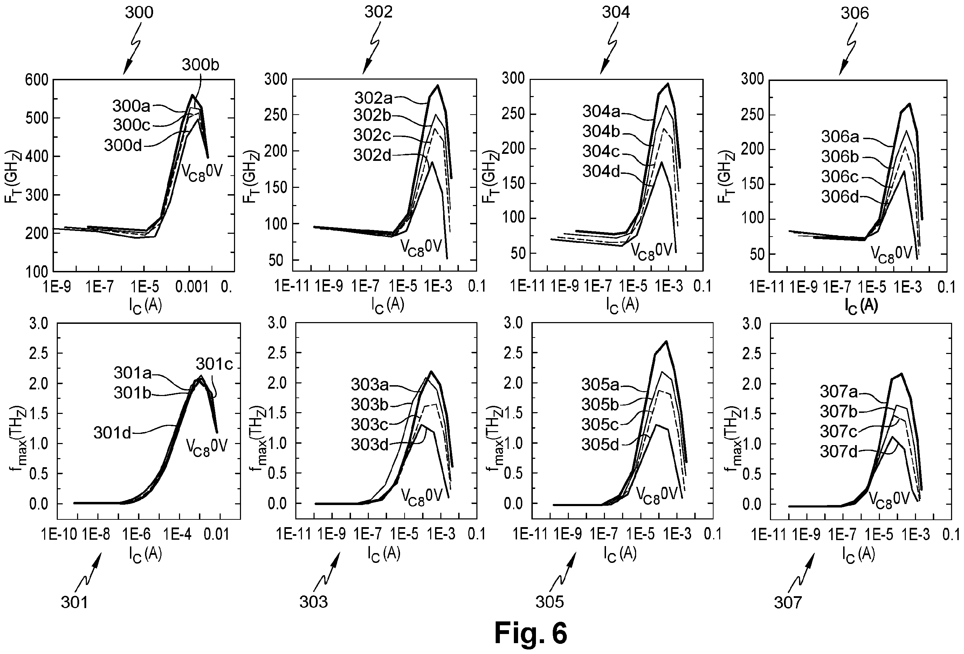

On verra dans la description des figures 6 à 8 qu'un transistor bipolaire latéral selon un mode de réalisation permet d'obtenir différents compromis entre rapidité (fréquence) et tension de claquage (avalanche) pour un même transistor, voire d'améliorer le compromis entre rapidité et tension de claquage pour un même transistor.

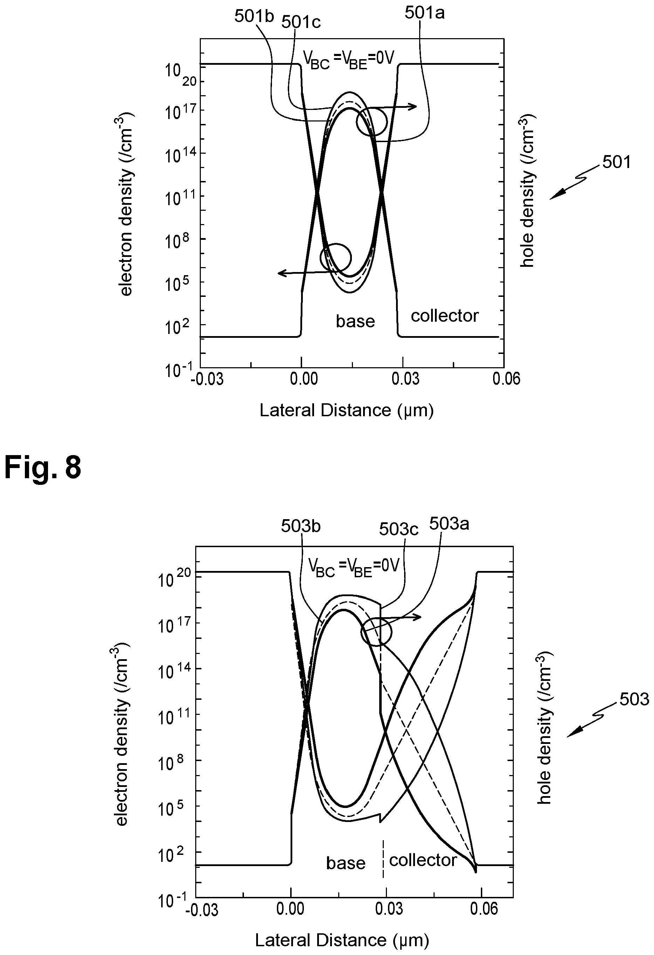

Selon un exemple, une polarisation positive du substrat peut être appliquée pour augmenter la rapidité du transistor, correspondant à une configuration à région de base de faible largeur et/ou à région de collecteur fortement dopée, comme on le verra dans la description de la figure 6 et de la figure 8.

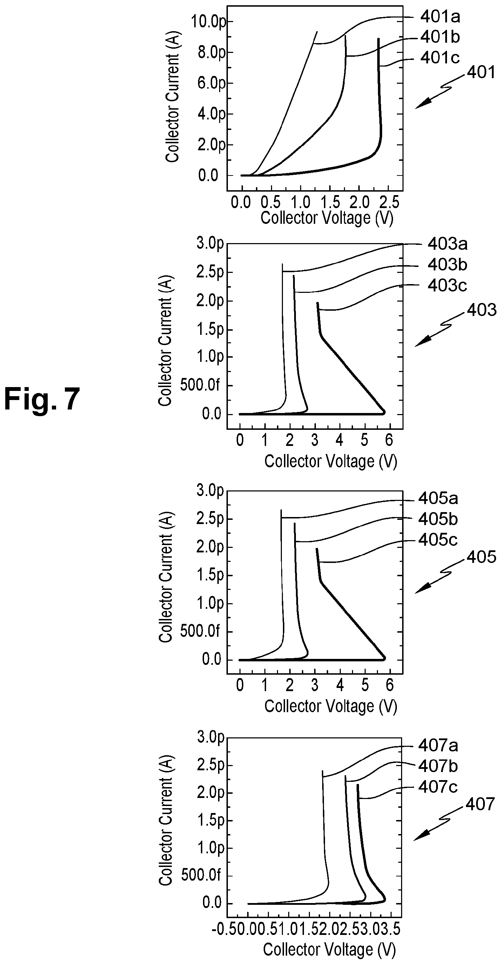

Selon un autre exemple, une polarisation négative du substrat peut être appliquée pour augmenter la tension de claquage, correspondant à une configuration à région de base plus large et/ou à région de collecteur faiblement dopée, réduisant le champ électrique dans le collecteur et ainsi repoussant le claquage à une plus haute tension, comme on le verra dans la description de la figure 7.

Selon un exemple de réalisation pouvant s'appliquer aux transistors 100, 200, 300, on considère les dimensions suivantes, données à 10 % près, de préférence à 5 % près :
- largeur totale région d'émetteur (L12) : 60 nm ;
- largeur région d'émetteur siliciurée (L12') : 30 nm ;
- largeur totale région de collecteur (L16) : 60 nm ;
- largeur première sous-région de collecteur (L16a) : 30 nm ;
- largeur deuxième sous-région de collecteur (L16b) : 30 nm ;
- largeur région de collecteur siliciurée (L16') : 30 nm ;
- largeur région de base (L14) : 28 nm ;
- largeur base extrinsèque (L18) : 20 nm ;
- largeur tranchées isolantes (L22) : 30 nm ;
- épaisseur couche de silicium (e10) : 7 nm ;
- épaisseur couche d'isolant (e4) : 25 nm ;
- épaisseur base extrinsèque (e18) : 20 nm ;
- profondeur tranchées isolantes (e22) : 32 nm.

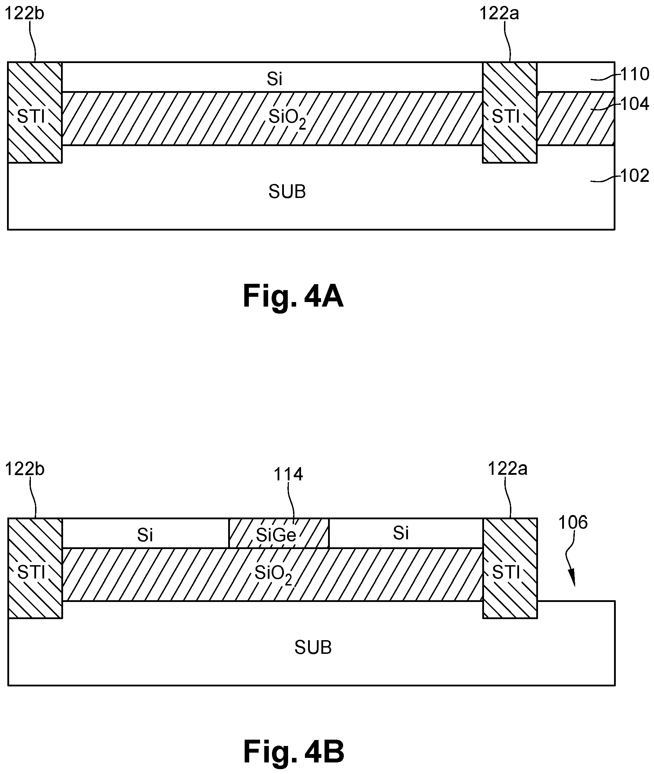

Les figures 4A à 4F sont des vues en coupe représentant des étapes d'un exemple de procédé de fabrication d'un transistor bipolaire latéral, décrit en référence au transistor 100 de la figure 1.

On part d'un substrat SOI, de préférence un FD-SOI, comprenant un substrat 102 (SUB) en un semiconducteur, un isolant 104 créé dans le substrat 102 en utilisant, par exemple, un procédé SIMOX ou un procédé SMARTCUT, et une fine couche de silicium monocristallin 110 (Si) sur l'isolant 104. Par exemple, le substrat 102 est à base de silicium. L'isolant 104 peut être un oxyde (BOX), par exemple à base de dioxyde de silicium (SiO₂).

De préférence, la fine couche de silicium 110 a une épaisseur comprise entre quelques nanomètres et une quinzaine de nanomètres, par exemple entre 5 et 15 nm.

De préférence, la couche d'isolant 104 a une épaisseur comprise entre quelques nanomètres et quelques dizaines de nanomètres, par exemple entre 10 et 50 nm.

La figure 4A représente une structure obtenue à l'issue d'une étape de formation de tranchées isolantes (STI) 122a, 122b à partir de la fine couche de silicium 110 jusqu'à une certaine profondeur, par exemple entre environ 30 et 300 nm, dans la couche de substrat 102.

De telles tranchées isolantes peuvent être formées par gravure puis remplissage, par un matériau isolant électrique, des parties gravées. Le matériau isolant est par exemple un oxyde, tel qu'un oxyde de silicium.

Ensuite, le procédé comprend une étape de formation d'une région de substrat 106 sans SOI, ou région NO-SO, dans laquelle la couche de silicium 110 et la couche d'isolant 104 ont été gravées, selon les techniques connues de la personne du métier, afin d'accéder à la couche de substrat 102. Cette région NO-SO est formée latéralement de l'autre côté de la première tranchée isolante 122a par rapport à la région de collecteur 116.

Selon un mode de réalisation, une étape d'épitaxie sélective peut être réalisée après gravure afin de garder une surface plane sur la région NO-SO.

En outre, le procédé peut comprendre une étape de formation de la région de base 114 en SiGe, dans la fine couche de silicium 110.

Plusieurs techniques connues de la personne du métier existent pour former une région en SiGe dans une couche de Si. On peut citer, par exemple, une technique de condensation qui consiste à déposer, sur une portion de la fine couche de Si destinée à former la région de base, une couche de SiGe. Cette couche de SiGe peut être déposée par épitaxie sélective, à l'aide d'un masque dur en un matériau diélectrique, par exemple du SiO₂, formé sur la fine couche de Si préalablement au dépôt de SiGe. Ce masque dur comprend un trou au niveau de la portion de la fine couche de Si destinée à former la région de base. Ensuite, on effectue une étape d'oxydation à une température d'environ 700°C et 900°C. Durant cette étape, du germanium de la couche de SiGe diffuse dans la fine couche de Si. Le masque dur est ensuite enlevé, par exemple par un traitement chimique adapté.

La figure 4B représente une structure obtenue à l'issue de ces étapes de formation de la région NO-SO 106 et de formation de la région de base 114 en SiGe.

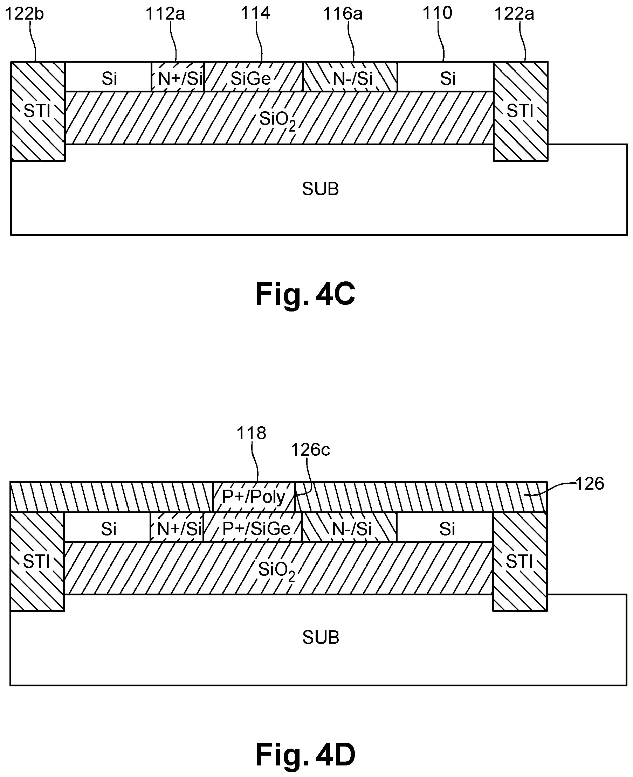

La figure 4C représente une structure obtenue à l'issue d'étapes de lithographie et implantation ionique, par exemple avec du phosphore ou de l'arsenic, réalisées dans la fine couche 110 afin de former de part et d'autre de la région de base 114 :
- une première sous-région 112a d'émetteur fortement dopée N (N+/Si) ; et
- une première sous-région 116a de collecteur faiblement dopée N (N-/Si).

Ensuite, un masque dur 126 en un matériau diélectrique, par exemple à base de TétraEthOxySilane (TEOS) pour former du SiO₂, est formé sur la fine couche de silicium 110 (partiellement dopée) et sur les tranchées isolantes 122a, 122b. Ce masque dur 126 comprend un trou 126c positionné au droit de la région de base 114, la largeur dudit trou correspondant sensiblement à la largeur de la base extrinsèque 118 formée sur ladite région de base, et étant sensiblement inférieure à la largeur de la région de base. Par exemple, le masque dur 126 est formé par dépôt du matériau diélectrique, puis le trou 126c est formé par photolithographie suivie d'une gravure.

Une étape d'épitaxie sélective de polysilicium dopé bore (P+/Poly) est réalisée dans le trou 126c afin de former la base extrinsèque 118. Le bore du polysilicium vient diffuser dans le SiGe de la région de base 114 afin de doper fortement en type P ladite région de base (P+/SiGe).

La figure 4D représente une structure obtenue à l'issue de ces étapes d'épitaxie et de dopage.

Ensuite, le masque dur 126 est partiellement retiré pour ne laisser qu'une première portion d'isolant 126a (premier espaceur) et une deuxième portion d'isolant 126b (deuxième espaceur) de part et d'autre de la base extrinsèque 118, s'étendant respectivement au droit de la première sous-région 112a d'émetteur et de la première sous-région 116a de collecteur, c'est-à-dire s'arrêtant sensiblement aux bords des portions de la fine couche de silicium 110 non encore dopées.

La figure 4E représente une structure obtenue à l'issue de cette étape de retrait du masque dur et d'étapes d'implantation ionique, par exemple avec du phosphore ou de l'arsenic, réalisées dans les portions non encore dopées de la fine couche de silicium 110 afin de former :
- une deuxième sous-région 112b d'émetteur fortement dopée N (N+/Si) ; et
- une deuxième sous-région 116b de collecteur fortement dopée N (N+/Si).

La figure 4F représente une structure obtenue à l'issue d'étapes de formation de portions de siliciure 130 sur la deuxième sous-région 112b d'émetteur, la deuxième sous-région 116b d'émetteur, sur la base extrinsèque 118 et sur au moins une portion de la région NO-SO 106, ainsi que des étapes de formation de prises de contact électrique 140 sur ces portions de siliciure. Sous la portion de région NO-SO 106 siliciurée peut avantageusement être prévue une zone 108 de fort dopage N+ ou P+. Toutes ces étapes ne sont pas détaillées ici, étant à la portée de la personne du métier.

Pour former le transistor bipolaire latéral selon le mode de réalisation de la figure 2 ou de la figure 3, le procédé décrit ci-avant peut s'appliquer, la zone du substrat située au moins sous la région NO-SO étant alors dopée. Pour un transistor bipolaire latéral 200 selon la variante de la figure 2, la zone 108 peut être dopée N+. Pour un transistor bipolaire latéral 300 selon la variante de la figure 3, la zone 108 peut être dopée P+.

Il ressort de cet exemple de procédé que le transistor bipolaire latéral asymétrique des modes de réalisation peut être facilement fabriqué à partir d'un procédé CMOS standard, sans ajouter de complexité supplémentaire de procédé. Ceci permet notamment de réaliser un transistor bipolaire à bas coût, tout en améliorant les performances par rapport à d'autres transistors bipolaires connus.

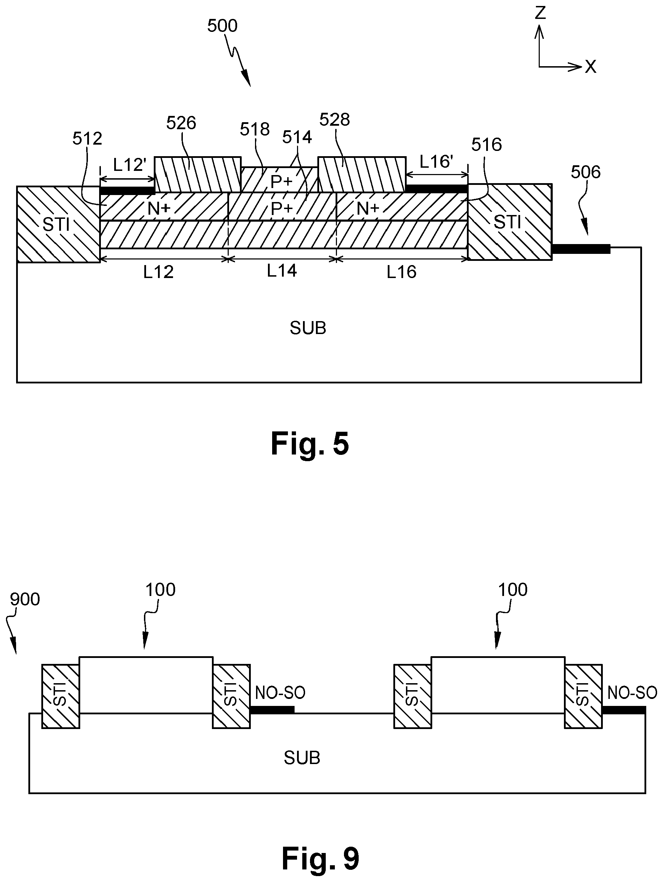

La figure 5 est une vue en coupe représentant un exemple de transistor bipolaire symétrique 500. Les régions d'émetteur 512 et de collecteur 516 présentent sensiblement les mêmes largeurs L12, L16 et un dopage sensiblement identique. En d'autres termes, la distance entre le collecteur 516 et la base 514 est sensiblement égale à la distance entre l'émetteur 512 et la base 514.

La figure 6 représente des courbes donnant la fréquence de transition du gain en courant (f_{T}) (courbes 300, 302, 304, 306) et la fréquence maximum d'oscillation (fₘₐₓ) (courbes 301, 303, 305, 307) en fonction du courant de collecteur (I_{C}), et ce, pour plusieurs valeurs de polarisation du substrat (V_{SUB}), et pour plusieurs exemples de transistors bipolaires latéraux : les courbes 300 et 301 correspondent au transistor symétrique 500, les courbes 302 et 303 correspondent au transistor asymétrique 100, les courbes 304 et 305 correspondent au transistor asymétrique 200 avec dopage N, et les courbes 306 et 307 correspondent au transistor asymétrique 300 avec dopage P ; les courbes 300a, 301a, 302a, 303a, 304a, 305a, 306a, 307a correspondent à une valeur de polarisation (V_{SUB}) de 2V ; les courbes 300b, 301b, 302b, 303b, 304b, 305b, 306b, 307b correspondent à une valeur de polarisation (V_{SUB}) de 1V ; les courbes 300c, 301c, 302c, 303c, 304c, 305c, 306c, 307c correspondent à une valeur de polarisation (V_{SUB}) de 0V (pas de polarisation) ; et les courbes 300d, 301d, 302d, 303d, 304d, 305d, 306d, 307d correspondent à une valeur de polarisation (V_{SUB}) de -1V.

La figure 7 représente des courbes I(V) donnant le courant de collecteur (collecter current I) en fonction de la tension du collecteur (collecter voltage V), et ce, pour plusieurs valeurs de polarisation du substrat (V_{SUB}), et pour plusieurs exemples de transistors bipolaires latéraux : les courbes 401 correspondent au transistor symétrique 500, les courbes 403 correspondent au transistor asymétrique 100, les courbes 405 correspondent au transistor asymétrique 200 avec dopage N, et les courbes 407 correspondent au transistor asymétrique 300 avec dopage P ; les courbes 401a, 403a, 405a, 407a correspondent à une valeur de polarisation (V_{SUB}) de 2V ; les courbes 401b, 403b, 405b, 407b correspondent à une valeur de polarisation (V_{SUB}) de 0V (pas de polarisation) ; et les courbes 401c, 403c, 405c, 407c correspondent à une valeur de polarisation (V_{SUB}) de -2V.

La figure 8 représente des courbes donnant la densité d'électrons (/cm³) et la densité de trous (/cm³) en fonction de la distance latérale par rapport à la jonction base/émetteur (point 0) en um, et ce, pour plusieurs valeurs de polarisation du substrat (V_{SUB}), et pour plusieurs exemples de transistors bipolaires latéraux : les courbes 501 correspondent au transistor symétrique 500, et les courbes 503 correspondent au transistor asymétrique 100 ; les courbes 501a, 503a correspondent à une valeur de polarisation (V_{SUB}) de 2V ; les courbes 501b, 503b correspondent à une valeur de polarisation (V_{SUB}) de 0V (pas de polarisation) ; et les courbes 501c, 503c correspondent à une valeur de polarisation (V_{SUB}) de -2V.

Comme indiqué ci-dessus, les courbes des figures 6 et 7 ont été tracées en comparant les transistors latéraux asymétriques 100, 200, 300 et le transistor latéral symétrique 500, et les courbes de la figure 8 ont été tracées en comparant le transistor latéral asymétrique 100 et le transistor latéral symétrique 500. Pour ces transistors, la concentration de germanium dans l'alliage SiGe de la région de base est d'environ 20% et les dopages des différentes régions, pour chacun des transistors 100, 200, 300, 500 sont ceux indiqués dans le tableau 1 ci-dessous.

**[Table 1]**

| Dopage (at/cm²) | 100 | 200 | 300 | 500 |
|---|---|---|---|---|
| Emetteur/Collecteur/ Base extrinsèque (zones extrinsèques, i.e. sous contact) | 5.10²⁰ | 5.10²⁰ | 5.10²⁰ | 5.10²⁰ |
| Emetteur (zone intrinsèque, i.e. sous portion d'isolant) | 4.10²⁰ | 4.10²⁰ | 4.10²⁰ | 4.10²⁰ |
| Collecteur (zone intrinsèque, i.e. sous portion d'isolant, modulée par la polarisation) | 1.10¹⁷ | 1.10¹⁷ | 1.10¹⁷ | 4.10²⁰ |
| Base intrinsèque | 3.10¹⁸ | 3.10¹⁸ | 3.10¹⁸ | 3.10¹⁸ |
| Zone NO-SO | Sans dopage | 1.10²⁰ à 1.10¹⁵ (gaussienne) | 1.10²⁰ à 1.10¹⁵ (gaussienne) | Sans dopage |

En outre, les dimensions des transistors 100, 200, 300 utilisés pour tracer les courbes des figures 6 et 7 sont données dans l'exemple de réalisation décrit plus avant, les épaisseurs et profondeur du transistor 500 sont les mêmes que celles données pour les transistors 100, 200, 300 et les largeurs du transistor 500 sont les suivantes :
- largeur totale région d'émetteur (L12) : 60 nm ;
- largeur région d'émetteur siliciurée (L12') : 30 nm ;
- largeur totale région de collecteur (L16) : 60 nm ;
- largeur région de collecteur siliciurée (L16') : 30 nm ;
- largeur de la région de base (L14) : 28 nm ;
- largeur de base extrinsèque (L18) : 20 nm.

Il ressort de l'analyse des courbes de la figure 6 que :
- la polarisation du substrat permet de moduler (augmenter) des caractéristiques de fréquence de transition du gain en courant (f_{T}) et de fréquence maximum d'oscillation (fₘₐₓ) d'un transistor asymétrique, alors qu'elle ne le permet pas, ou très faiblement, avec un transistor symétrique ;
- les fréquences augmentent avec la tension de polarisation appliquée : en particulier, il faut appliquer une tension de polarisation positive pour augmenter les fréquences du transistor, et ainsi la rapidité et le gain en puissance du transistor ;
- un dopage de type N du substrat sous la région de collecteur et la région NO-SO (transistor 200) augmente les fréquences, et ainsi a un impact positif sur l'efficacité de la polarisation du substrat sur les fréquences ;
- un dopage de type P du substrat sous la région de collecteur et la région NO-SO (transistor 300) a un impact plutôt négatif sur l'efficacité de la polarisation du substrat.

Ainsi, une polarisation positive du substrat peut être appliquée pour augmenter la rapidité du transistor. Ceci correspond à une configuration avec accumulation d'électrons dans le collecteur et une diminution de trous dans la base, comme on peut le voir dans la figure 8. Une polarisation positive (courbe 503a) entraine un déplacement de la zone de charge d'espace base-collecteur vers la base, impliquant une largeur de base neutre plus faible, et une région de collecteur plus fortement dopée électrostatiquement, repoussant ainsi les effets de forte injection à des densités de courant plus élevées. Par ailleurs, la capacité de jonction base-émetteur est réduite par la diminution de trous dans la base. On voit aussi sur la figure 8, en comparant les courbes 503 avec les courbes 501, que la polarisation a un effet très marqué sur un transistor asymétrique (courbes 503), alors qu'elle n'en a peu, voire pas, sur un transistor symétrique (courbes 501).

Il ressort de l'analyse des courbes de la figure 7 que :
- la polarisation du substrat permet de moduler (augmenter) des caractéristiques de tension de claquage d'un transistor asymétrique, alors qu'elle le permet beaucoup moins avec un transistor symétrique : par exemple, on reste en dessous de 2,5 V pour un transistor symétrique alors qu'on peut dépasser 3 V pour un transistor symétrique ;
- la tension de claquage augmente avec la tension de polarisation appliquée : en particulier, il faut appliquer une tension de polarisation négative pour augmenter la tension de claquage du transistor et ainsi réduire le phénomène d'avalanche ;
- un dopage de type N du substrat sous la région de collecteur et la région NO-SO (transistor 200) n'a pas d'impact sur l'efficacité de la polarisation du substrat et sur la tension de claquage ;
- un dopage de type P du substrat sous la région de collecteur et la région NO-SO (transistor 300) peut avoir un impact positif sur l'efficacité de la polarisation du substrat et sur la tension de claquage.

Ainsi, il ressort des figures 6 à 8 que l'application d'une tension de polarisation au substrat combiné avec le caractère asymétrique du transistor permet de contrôler des caractéristiques dudit transistor, et en particulier de moduler le compromis entre rapidité et tension de claquage.

Un transistor, ou plusieurs transistors, selon un mode de réalisation peu(ven)t être intégré(s) dans un circuit électronique 900, comme illustré dans la figure 9, représentant deux transistors bipolaires latéraux asymétriques 100 selon un mode de réalisation avec chacun une région NO-SO sur un même substrat SUB (transistors représentés très schématiquement). Il peut s'agir de plusieurs transistors sensiblement similaires, mais auxquels sont appliquées des tensions de polarisation différentes. Il peut aussi s'agir de plusieurs transistors différents, avec des mêmes tensions de polarisation ou des tensions de polarisation différentes. Le circuit électronique peut comporter d'autres composants électroniques.

Les applications préférées, bien que non limitatives, du transistor selon un mode de réalisation sont dans les systèmes requérant à la fois des fonctions numériques denses et des fonctions RF (Radio-Fréquence), par exemple les infrastructures 5G ou 6G, ou les radars, notamment les radars automobile longue portée, et plus généralement les systèmes de communication, que ce soit par fibre optique ou sans fil, incluant les systèmes portatifs mais également les systèmes d'imagerie millimétrique.

Une application particulièrement avantageuse du transistor selon un mode de réalisation concerne les dispositifs Bi-CMOS (bipolaire complémentaire métal-oxyde-semiconducteur), qui combinent des transistors bipolaires et CMOS sur une même puce de circuit intégré, bénéficiant ainsi à la fois des caractéristiques à grande vitesse de la technologie bipolaire et des caractéristiques de faible consommation de la technologie CMOS.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, le transistor peut être un autre transistor bipolaire latéral à hétérojonction (HBT), ou un transistor bipolaire latéral à homojonction (BJT).

Enfin, la mise en oeuvre pratique des modes de réalisation et variantes décrits est à la portée de la personne du métier à partir des indications fonctionnelles données ci-dessus.

## Revendications

1. Transistor bipolaire latéral (100 ; 200 ; 300) comprenant :
- une région d'émetteur (112) dopée d'un premier type de conductivité et présentant une première largeur (L12) ;
- une région de collecteur (116) dopée du premier type de conductivité, présentant une deuxième largeur (L16) supérieure à la première largeur (L12) de la région d'émetteur et une concentration moyenne de dopage inférieure à la concentration moyenne de dopage de la région d'émetteur ;
- une région de base (114) dopée du deuxième type de conductivité et positionnée latéralement entre la région d'émetteur et la région de collecteur ;
lesdites régions d'émetteur, de base et de collecteur étant disposées dans une couche de silicium (110) sur une couche d'isolant (104), ladite couche d'isolant étant sur un substrat semiconducteur (102) ;
- une région de substrat (106) dépourvue de la couche de silicium et de la couche d'isolant, et positionnée latéralement du côté de la région de collecteur (116) ; et
- un circuit de polarisation (150) relié à la région de substrat (106), et adapté à fournir à ladite région de substrat une tension de polarisation de manière à moduler le dopage électrostatique de la région de collecteur (116).

2. Transistor (100 ; 200 ; 300) selon la revendication 1, comprenant une base extrinsèque (118) présentant une troisième largeur (L18) et disposée sur la région de base (114) présentant une quatrième largeur (L14).

3. Transistor (100 ; 200 ; 300) selon la revendication 2, dans lequel la troisième largeur (L18) de la base extrinsèque (118) est inférieure à la quatrième largeur (L14) de la région de base (114), la base extrinsèque étant par exemple sensiblement centrée par rapport à la région de base.

4. Transistor (100 ; 200 ; 300) selon la revendication 2 ou 3, comprenant une première portion d'isolant (126a) sur une première portion (112a) de la région d'émetteur (112) et une deuxième portion d'isolant (126b) sur une première portion de la région de collecteur (116), la région de base (114) étant entre la première portion de la région d'émetteur et la première portion de la région de collecteur, et la base extrinsèque (118) étant entre la première portion d'isolant et la deuxième portion d'isolant.

5. Transistor selon l'une quelconque des revendications 1 à 4, dans lequel la couche de silicium (110) a une épaisseur (e10) comprise entre quelques nanomètres et une quinzaine de nanomètres, par exemple entre 5 et 15 nanomètres.

6. Transistor selon l'une quelconque des revendications 1 à 5, dans lequel la couche d'isolant (104) a une épaisseur (e4) comprise entre quelques nanomètres et quelques dizaines de nanomètres, par exemple entre 10 et 50 nanomètres.

7. Transistor (100 ; 200 ; 300) selon l'une quelconque des revendications 1 à 6, dans lequel la région d'émetteur (112) est formée par une région fortement dopée du premier type de conductivité.

8. Transistor (100 ; 200 ; 300) selon l'une quelconque des revendications 1 à 7, dans lequel la région de collecteur (116) comprend une première sous-région (116a) légèrement dopée du premier type de conductivité et une deuxième sous-région (116b) fortement dopée du premier type de conductivité.

9. Transistor (100 ; 200 ; 300) selon la revendication 8, dans lequel la première sous-région (116a) de la région de collecteur est entre la région de base (114) et la deuxième sous-région (116b) de la région de collecteur.

10. Transistor (100 ; 200 ; 300) selon la revendication 8 ou 9, dans lequel la première sous-région (116a) de la région de collecteur a une concentration moyenne de dopage en le premier type de conductivité inférieure à la concentration moyenne de dopage de la région de base (114) en le deuxième type de conductivité, par exemple d'un facteur d'au moins dix.

11. Transistor (100 ; 200 ; 300) selon l'une quelconque des revendications 1 à 10, dans lequel la région de base (114) comprend un alliage silicium et germanium (SiGe).

12. Transistor (100 ; 200 ; 300) selon l'une quelconque des revendications 1 à 11, comprenant une première tranchée isolante (122a) traversant la couche de silicium (110), la couche d'isolant (104) et, partiellement, le substrat semiconducteur (102), ladite première tranchée isolante étant positionnée latéralement entre la région de collecteur (116) et la région de substrat (106).

13. Transistor (100 ; 200 ; 300) selon l'une quelconque des revendications 1 à 12, comprenant une deuxième tranchée isolante (122b) traversant la couche de silicium (110), la couche d'isolant (104) et, partiellement, le substrat semiconducteur (102), la région d'émetteur (112) étant positionnée latéralement entre ladite deuxième tranchée isolante et la région de base (114).

14. Transistor (200 ; 300) selon l'une quelconque des revendications 1 à 13, dans lequel une zone (208 ; 308) du substrat (102) située au moins sous la région de substrat (106) dépourvue de la couche de silicium et de la couche d'isolant, et de préférence sous la région de collecteur (116), est dopée, par exemple avec un dopage graduel décroissant radialement depuis ladite région du substrat.

15. Transistor selon l'une quelconque des revendications 1 à 14, comprenant des prises de contact (140) sur la région d'émetteur (112), la région de collecteur (116), la région de substrat (106), et, dans certains cas, sur la base extrinsèque (118), le circuit de polarisation (150) étant relié à ladite région de substrat par une desdites prises de contact, une portion de siliciure (130) étant par exemple formée sous chaque prise de contact.

16. Procédé de fabrication d'un transistor bipolaire, ledit procédé comprenant :
- la fourniture d'une couche de silicium (110) sur une couche d'isolant (104), sur un substrat semiconducteur (102) ;
- la formation, dans la couche de silicium (110), d'une région d'émetteur (112) d'une première largeur (L12) dopée d'un premier type de conductivité ; d'une région de collecteur (116) dopée du premier type de conductivité avec une deuxième largeur (L16) supérieure à la première largeur (L12) et une concentration moyenne de dopage inférieure à la concentration moyenne de dopage de la région d'émetteur ; et d'une région de base (114) dopée du deuxième type de conductivité et formée latéralement entre ladite région d'émetteur et ladite région de collecteur ;
- la formation d'une région de substrat (106) dépourvue de la couche de silicium et de la couche d'isolant, ladite région de substrat étant formée latéralement du côté de la région de collecteur (116) ;
- la formation d'un circuit de polarisation (150) relié à la région de substrat (106), et adapté à fournir à ladite région de substrat une tension de polarisation de manière à moduler le dopage électrostatique de la région de collecteur (116).

17. Procédé selon la revendication 16, comprenant, préalablement à la formation des régions d'émetteur, de base, de collecteur et de substrat :
- la formation d'une première tranchée isolante (122a) dans la couche de silicium (110), la couche d'isolant (104), et partiellement dans le substrat (102), ladite première tranchée isolante étant formée latéralement entre la région de collecteur (116) et l'emplacement de la future région de substrat (106) ; et
- la formation d'une deuxième tranchée isolante (122b) dans la couche de silicium (110), la couche d'isolant (104) et partiellement dans le substrat (102), la région d'émetteur (112) étant positionnée latéralement entre ladite deuxième tranchée isolante et la région de base (114).

18. Procédé d'utilisation d'un transistor (100 ; 200 ; 300) selon l'une quelconque des revendications 1 à 15, ledit procédé comprenant l'application, par le circuit de polarisation (150), d'une tension de polarisation à la région de substrat (106).

19. Procédé selon la revendication 18, comprenant l'application d'une tension de polarisation positive à la région de substrat (106), de manière à augmenter la rapidité et/ou le gain du transistor.

20. Procédé selon la revendication 18, comprenant l'application d'une tension de polarisation négative à la région de substrat (106), de manière à augmenter la tension de claquage du transistor.

21. Circuit électronique (900) comprenant au moins un transistor (100 ; 200 ; 300) selon l'une quelconque des revendications 1 à 15.

22. Circuit électronique (900) comprenant plusieurs transistors (100 ; 200 ; 300) selon l'une quelconque des revendications 1 à 15, au moins deux transistors ayant des tensions de polarisation différentes appliquées à la région de substrat (106).
